**Europäisches Patentamt**

**European Patent Office**

**Office européen des brevets**

(11) Numéro de publication: **0 168 279**
**B1**

# (12) FASCICULE DE BREVET EUROPÉEN

(45) Date de publication du fascicule du brevet:
08.03.89

(21) Numéro de dépôt: **85401076.6**

(22) Date de dépôt: **31.05.85**

(51) Int. Cl.⁴: **G 01 R 11/24,** G 01 R 11/04

(54) Coffret, en particulier pour compteur électrique ou analogue.

(30) Priorité: **01.06.84 GB 8413973**

(43) Date de publication de la demande:
**15.01.86 Bulletin 86/3**

(45) Mention de la délivrance du brevet:
**08.03.89 Bulletin 89/10**

(84) Etats contractants désignés:
**AT BE CH DE FR IT LI LU NL SE**

(56) Documents cité:
**FR-A-2 235 255**
**US-A-2 113 306**
**US-A-4 188 575**

(73) Titulaire: **MANUFACTURE D'APPAREILLAGE
ELECTRIQUE DE CAHORS, B.P.149 Regourd,
F-46003 Cahors Cédex (FR)**

(72) Inventeur: **Bourrieres, Pierre, 135 rue de la Barre,
F-46000 Cahors Cédex (FR)**

(74) Mandataire: **Bouju, André, Cabinet Bouju 38
avenue de la Grande Armée, F-75017 Paris (FR)**

## Description

La présente invention concerne un coffret pour compteur électrique ou analogue et, de façon plus générale, pour tout appareil nécessitant une protection contre la fraude, le vol, etc.

La porte - ou couvercle - de tels coffrets peut être munie de tout moyen bien connu de verrouillage tels que ceux fonctionnant avec une clé et tels que décrits par exemple dans US-A-4 188 575. La fraude est théoriquement interdite si la porte a été effectivement fermée et verrouillée au moyen de la clé. Toutefois la clé, ou un passe-partout, peut être volée ou imitée; il en résulte que le coffret n'est plus sûr. En outre, intentionnellement ou non, le coffret peut paraître fermé alors qu'en réalité il n'est pas verrouillé au moyen de la clé. Ceci permet un trafic frauduleux entre, par exemple, un consommateur d'électricité et un préposé, le préposé étant payé pour "oublier" de verrouiller le coffret au moyen de la clé.

On pourrait penser résoudre ce problème en prévoyant des moyens de fermeture par loquet à ressort pour la porte ou couvercle, à la place d'une clé. Toutefois, il est aisé de frauder un moyen de fermeture par loquet à ressort, quel qu'il soit, en obturant avec un corps étranger le logement prévu pour recevoir le loquet du moyen de fermeture à ressort. Le couvercle peut alors être fermé normalement et rester ainsi; toutefois, au lieu d'être verrouillé en place, le couvercle est ensuite facile à réouvrir puisque l'on a empêché le loquet de s'engager dans son logement. Par conséquent, un trafic semblable à celui ci-dessus reste possible.

Le but de l'invention est de proposer un coffret rendant un tel trafic frauduleux au moins beaucoup plus difficile.

Selon l'invention, le coffret, en particulier pour compteur électrique ou analogue nécessitant une protection contre la fraude, le vol et autre, comprenant deux éléments de boîtier, à savoir, un corps creux muni d'une ouverture et un couvercle prévu pour fermer l'ouverture du corps, un premier des éléments de boîtier portant un mécanisme de verrouillage actionnable par une clé et comprenant un organe de verrouillage mobile par rapport audit premier élément de boîtier entre une position de verrouillage dans laquelle il est en prise avec des moyens de retenue de l'autre élément de boîtier lorsque le coffret est fermé et une position déverrouillée, est caractérisé en ce que le mécanisme de verrouillage est prévu pour permettre d'enlever la clé lorsque l'organe de verrouillage est en position de verrouillage et pour retenir la clé, sans possibilité d'enlèvement, lorsque l'organe de verrouillage est en position déverrouillée, et en ce que le coffret comporte des moyens pour maintenir de façon irréversible l'organe de verrouillage en position de verrouillage lorsque ce dernier et les moyens de retenue sont en prise mutuelle

Ainsi, lorsque le couvercle a été correctement fermé et verrouillé avec la clé, le préposé retire la clé. Comme celle-ci ne peut être enlevée que si l'organe de verrouillage occupe la position verrouillée, en ramenant la clé, le préposé prouve que l'organe de verrouillage a été placé en position verrouillée. On pourrait penser que le préposé pourrait mettre l'organe de verrouillage en position verrouillée tout en maintenant le couvercle écarté du corps. En fait ceci arrivera rarement car l'organe de verrouillage en position verrouillée empêcherait que le couvercle s'adapte sur le corps. Le couvercle resterait alors visiblement ouvert et la fraude serait trop évidente. Une fois le couvercle correctement verrouillé, l'organe de verrouillage est automatiquement et irréversiblement maintenu en position verrouillée. Il n'est pas possible de réouvrir le couvercle, même avec la clé ou un passe-partout. Il est donc inutile de voler ou de copier la clé. Comme mentionné ci-dessus, la clé n'est désormais rien d'autre que la preuve que le couvercle a bien été correctement fermé.

Dans un mode de réalisation préféré, il est prévu un moyen qui repousse le couvercle vers une position ouverte dégageant l'ouverture du corps. Le couvercle ne peut donc pas rester partiellement fermé si l'organe de verrouillage n'est pas en prise avec les moyens de retenue. Par conséquent le couvercle est soit fermé et verrouillé soit grand ouvert, ce qui rend la fraude très visible si le préposé tente de retirer la clé sans avoir mis en prise l'organe de verrouillage et les moyens de retenue.

De préférence, une partie des moyens pour maintenir l'organe de verrouillage en position verrouillée sont portés par ledit autre élément de boîtier. Ainsi l'organe de verrouillage ne peut être retenu en position de verrouillage que si le couvercle est ajusté sur le corps, et non en manoeuvrant la clé par inadvertance avant d'avoir fermé le couvercle

D'autres particularités et avantages de l'invention ressortiront encore de la description détaillée d'un exemple non limitatif, en se référant aux dessins annexés, auxquels:

- la figure 1 est une vue schématique en perspective éclatée d'un coffret conforme à l'invention;
- la figure 2 est une vue en perspective éclatée, à échelle agrandie, d'un bloc de retenue du corps et d'une plaque de retenue du couvercle;
- la figure 3 est une vue partielle du coffret en coupe selon un plan vertical perpendiculaire au plan de l'ouverture du corps;
- la figure 4 est une vue en perspective, partiellement en coupe, des moyens de fixation du corps;
- la figure 5 est une vue partielle du coffret, en coupe selon la ligne V - V de la figure 3;
- la figure 6 est une vue partielle du couvercle selon la flèche VI de la figure 1, le loquet étant en position déverrouillée;
- les figures 7 et 8 sont respectivement une vue en plan et en élévation du loquet;
- les figures 9 et 10 sont respectivement une vue en plan et une vue latérale de la plaque de retenue du couvercle;

- la figure 11 est une vue du bloc de retenue du corps, en coupe selon la ligne XI - XI de la figure 5;

- la figure 12 est un détail de la figure 11 à échelle agrandie, montrant également une partie du loquet coopérant avec la goupille d'immobilisation avant que la goupille ne vienne bloquer par ressort ce loquet;

- les figures 13 et 14 montrent à deux stades successifs, selon la flèche XIII de la figure 1, la goupille débarrassant le loquet d'un objet étranger mis en place pour interdire frauduleusement l'immobilisation du loquet en position verrouillée, le loquet étant représenté en coupe selon la ligne XIII - XIII de la figure 8.

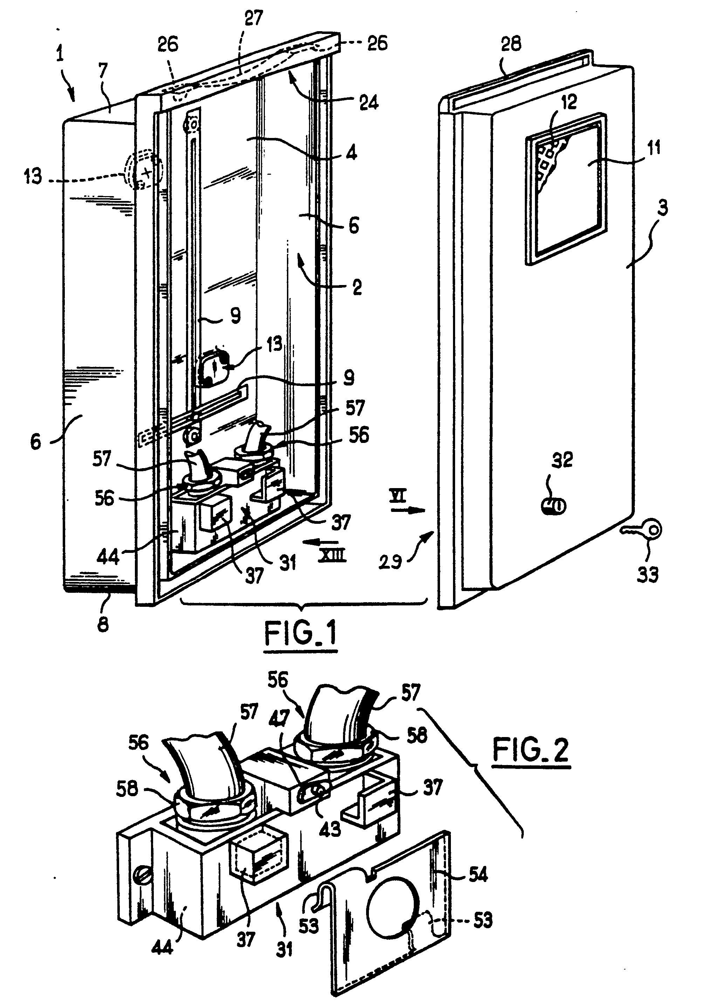

Comme représenté sur la figure 1, un coffret conforme à l'invention comporte deux éléments de boîtier, c'est-à-dire d'une part un corps creux 1, sensiblement parallélépipédique, dont une grande face constitue une ouverture 2, et d'autre part un couvercle rectangulaire 3 prévu pour clore l'ouverture 2.

Le corps 1 présente une paroi 4 opposée à l'ouverture 2, des parois latérales 6, une paroi supérieure 7, sensiblement horizontale, et une paroi inférieure, sensiblement horizontale 8.

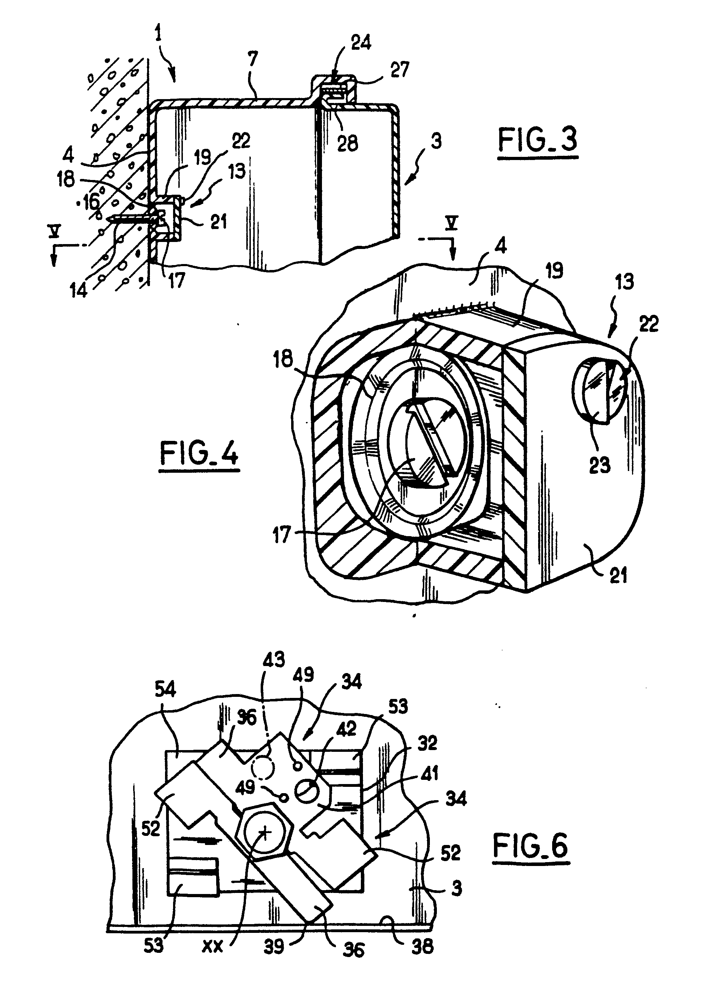

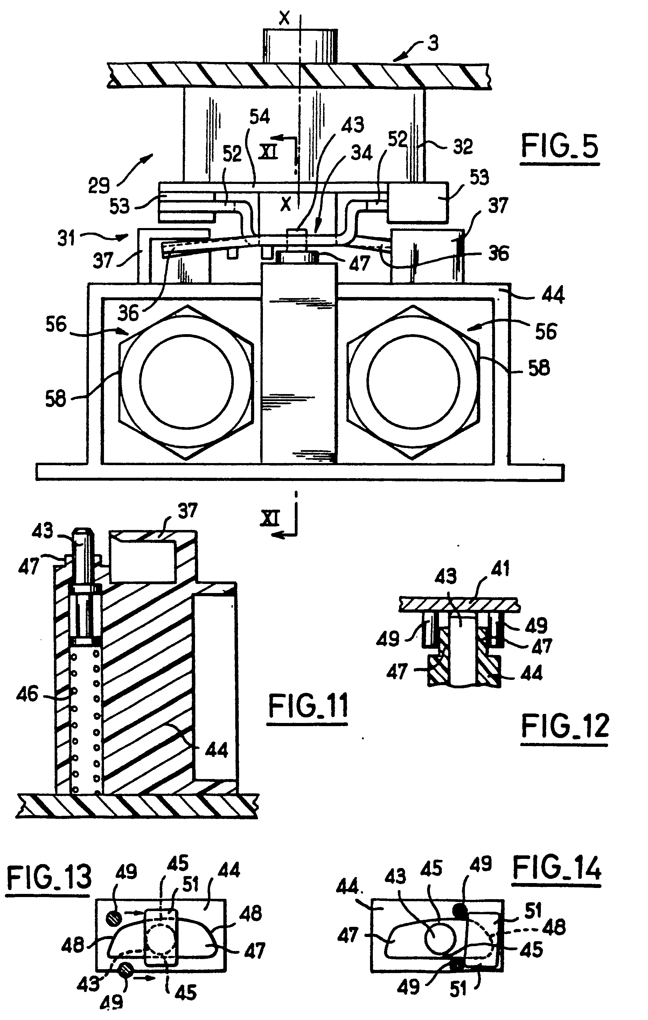

La face interne de la paroi 4 porte des moyens bien connus 9 pour fixer un compteur électrique ou appareil semblable nécessitant une protection contre la fraude. Le couvercle 3 comporte une fenêtre 11 permettant de lire le compteur électrique sans ouvrir le coffret. La fenêtre 11 est renforcée intérieurement par une grille 12. Le corps 1 peut être fixé à un support tel qu'un mur d'une maison au moyen de dispositifs de fixation 13, dont l'un est montré sur les figures 3 et 4. Chaque dispositif 13 comporte une vis 14 prévue pour être vissée dans le mur 16, avec sa tête 17 sur la face interne de la paroi 4 du corps 1. La région de la paroi 4 qui reçoit la tête 17 est raccordée au reste de la paroi 4 par une liaison mince et cassable 18. La liaison 18 est à son tour entourée d'une paroi annulaire 19 faisant saillie vers l'ouverture 2. L'espace entouré par la paroi 19 est fermé par un couvercle 21 fixé à la paroi 19 par des vis 22. La tête 23 de ces vis, qui est à l'intérieur du corps 1, est d'un type spécial connu permettant de la visser à l'aide d'un tournevis mais non de la dévisser.

Le corps 1 et le couvercle 3 ainsi que le couvercle 21 peuvent être en matériau plastique, les liaisons 18 étant obtenues par moulage convenable dudit matériau.

L'ouverture 2 s'étend dans un plan vertical. Comme représenté sur les figures 1 et 3, le bord supérieur de l'ouverture 2 présente une rainure ouvrant vers le bas 24. Les deux extrémités 26 d'un ressort à lame 27 sont fixées contre la face supérieure de la rainure 24. Entre ses extrémités 26, la lame 27 forme un arc vers le bas. Le bord supérieur du couvercle 3 présente une nervure 28 prévue pour s'engager dans la rainure 24. Les autres bords de l'ouverture 2 et du couvercle 3 peuvent être placés l'un contre l'autre de façon à clore l'ouverture 2, mais aucun moyen autre que la rainure 24 et la nervure 28 ne sont prévus pour maintenir le couvercle 3 contre le corps 1, à l'exception de moyens de verrouillage - 29 dans le couvercle 3 et 31 dans le corps 1 - que l'on va décrire ci-dessous. La disposition est telle qu'il est nécessaire que la nervure 28 comprime la lame 27 pour que les bords de l'ouverture 2 et ceux du couvercle 3 viennent en face l'un de l'autre et pour que les moyens de verrouillage 29, 31 puissent coopérer. Donc, si les moyens de verrouillage 29, 31 ne sont pas en prise, il n'est pas possible d'ajuster le couvercle 3 sur le corps 1 de façon stable, mais uniquement d'une façon telle que le couvercle 3 va s'ouvrir en glissant verticalement sous l'effet de son propre poids.

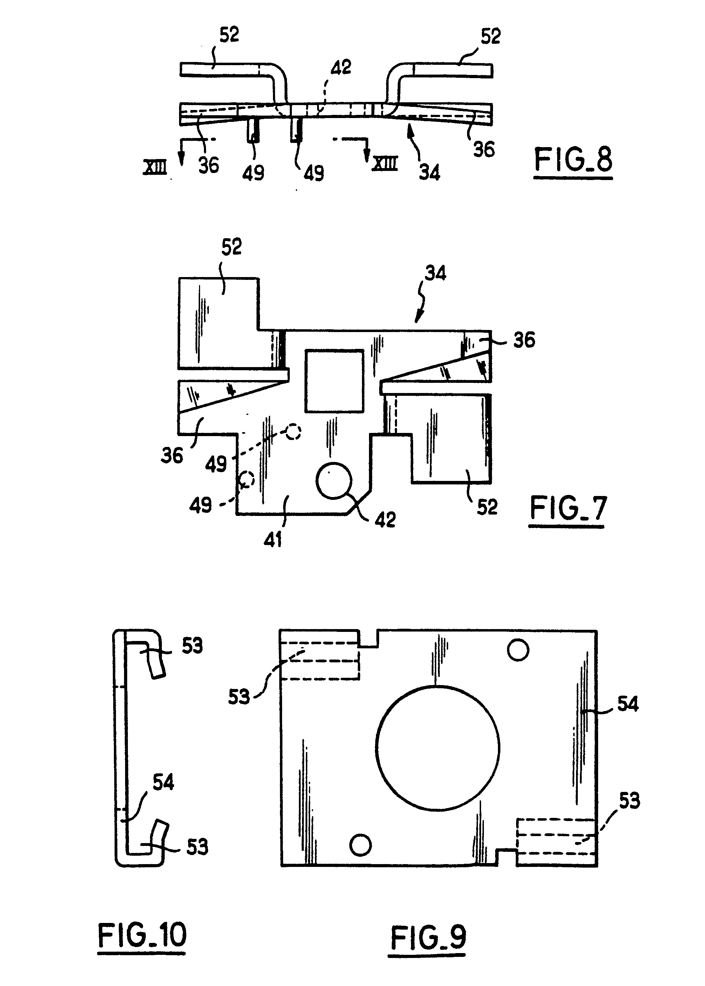

Comme représenté sur les figures 1, et 5 à 8, les moyens de verrouillage portés par le couvercle 3 comportent un mécanisme de verrouillage 29 comprenant une serrure 32 actionnée par une clé 33 et manoeuvrant elle-même un organe de verrouillage ou loquet 34 qui peut tourner autour d'un axe XX perpendiculaire au plan de l'ouverture 2 lorsque le couvercle clôt ladite ouverture. Le loquet 34 est mobile entre une position de verrouillage (figure 5) et une position déverrouillée (figure 6) en tournant autour de l'axe XX. En position de verrouillage, deux ailes 36, diamètralement opposées, du loquet 34 viennent respectivement en prise avec deux gâches 37 appartenant aux moyens de verrouillage 31 portés par le corps 1. Les gâches 37 sont des logements symétriques l'un de l'autre par rapport à un axe qui correspond à l'axe XX lorsque le couvercle 3 clôt le corps 1. Chaque logement 37 est ouvert en direction dudit axe ainsi que d'un côté autorisant l'entrée de l'aile correspondante 36. En position déverrouillée, les ailes 36 sont dégagées des logements 37.

La serrure 32 est prévue pour ne permettre de retirer la clé 33 que lorsque le loquet 34 se trouve dans la position verrouillée mentionnée ci-dessus. Dans l'exemple représenté, ceci résulte de ce que la serrure 32 est fixée au couvercle 3 près d'un épaulement inférieur 38 de ce dernier de sorte que l'une des ailes 36 vient buter en 39 (figure 6) contre cet épaulement 38 lorsque le loquet 34 a effectué une rotation d'environ 45° à partir de la position de verrouillage. Cet appui définit la position déverrouillée, dans laquelle les ailes 36 sont dégagées des logements 37. La serrure 32 peut donc être d'un type conventionnel permettant de retirer la clé 33 en plusieurs positions, l'appui 39 interdisant à la clé 33 de prendre une position de retrait autre que la position de verrouillage du loquet 34.

Le loquet 34 comporte également une plaque 41 munie d'un trou 42 (figure 6) placé de façon à correspondre et à être occupé par une goupille 43 sollicitée par un ressort 46 (figures 2 et 11) et montée à coulisse, selon une direction perpendiculaire au plan de l'ouverture 2, dans un bloc de retenue 44 qui porte également les gâches 37. La plaque 41 est suffisament grande pour repousser la goupille 43 à l'intérieur du bloc de retenue 44, à l'encontre de l'action du ressort 46, même lorsque le loquet 34 se trouve en position déverrouillée. Ceci est représenté figure 6 par la position de la goupille 43 en trait mixte. La plaque 41 s'étend également le long de la totalité du trajet de la goupille 43, depuis la position représentée en trait mixte jusqu'au trou 42. On comprendra ainsi que la plaque 41 avec le trou 42 et la goupille 43 constituent des moyens de blocage à ressort prévus pour immobiliser le loquet 34 en position de verrouillage lorsque ledit loquet a atteint la position verrouillée alors que le couvercle clôt l'ouverture 2.

Comme représenté aux figures 2 et 11 à 14, la goupille 43 est entourée d'un bossage 47 en forme de bateau, allongée dans la direction de la course du trou 42 devant la goupille 43. Comme on le voit sur les figures 13 et 14, le bossage 47 présente sa plus large dimension transversale près de deux régions diamètralement opposées de la goupille 43 et, en ces endroits, il est constitué de deux parois très minces 45 entre lesquelles est prévu un trou pour la goupille 43.

On peut également noter sur la figure 13 que les deux petits côtés 48 du bossage 47 sont inclinés l'un par rapport à l'autre sous un angle aigu.

Comme le montre la figure 6, la plaque 41 porte deux tenons 49 dirigés vers le corps 1 et disposés de chaque côté du trajet de la goupille 43 sur la plaque 41 entre la position représentée en trait mixte et le trou 42. Comme le montrent les figures 13 et 14, au cours de la rotation du loquet, le bossage 47 passe entre les tenons 49 prévus pour débarrasser le bossage 47 de tout objet étranger tel qu'une pièce 51 en forme de U qui pourrait avoir été placée sur le bossage 47 pour interdire le fonctionnement de la goupille 43 et interdire ainsi le blocage par ressort du loquet 34 par la goupille 43, dans le but de rendre la clé 33 opérationnelle pour réouvrir le coffret après son verrouillage apparemment correct. La distance entre les tenons 49 est sensiblement égale à la plus grande dimension transversale du bossage 47. La forme en bateau du bossage 47 permet à ce bossage 47 de pénétrer facilement entre les tenons 49 alors que ces tenons 49 viennent frotter contre les parois 45. Du fait que les faces 48 du bossage 47 sont relativement étroites, loin l'une de l'autre et inclinées l'une par rapport à l'autre, il serait très difficile de fixer contre elles une pièce en forme de U.

Selon une autre particularité de l'invention, le loquet 34 (figure 6) comporte deux autres ailes 52, diamètralement opposées, contre-coudées (figure 5) de sorte que leur trajet évite les logements 37. Les ailes 52 sont prévues pour coopérer avec deux gâches respectives 53, en forme de gouttière, disposées symétriquement par rapport à l'axe XX et portées par une plaque 54 fixée au couvercle 3 entre le loquet 34 et la serrure 32. Les gâches 53 sont disposées de façon que les deux ailes 52 soient en prise avec les gâches 53 lorsque les deux ailes 36 sont en prise avec les logements 37.

Selon une autre particularité de l'invention, le bloc de retenue 44 est prévu pour y recevoir deux pressegarnitures 56 à travers lesquels passent les conducteurs électriques 57 raccordant le compteur électrique au réseau et respectivement à l'installation de l'utilisateur. Chaque presse-garniture 56 comporte une vis de presse-garniture 58 que l'on ne peut atteindre que de l'antérieur du corps 1 et non de son extérieur.

Le coffret que l'on vient de décrire fonctionne de la façon suivante.

Le couvercle 3 étant séparé du corps 1, on fixe ce dernier à un support tel que le mur 16 au moyen des vis 14 puis on fixe les couvercles 21 sur les parois respectives 19 au moyen des vis spéciales 22. Puis on fixe un compteur électrique et/ou un autre appareil au corps 1 au moyen des glissières 9. On introduit les conducteurs 57 dans les presse-garnitures 56 et on serre les vis 58 depuis l'antérieur du corps 1. On raccorde ensuite les conducteurs 57 à l'appareil ou aux appareils. Le loquet étant en position déverrouillée, le préposé place le couvercle 3 sur le corps 1 en introduisant la nervure 28 (figure 1) dans la rainure 24 tout en comprimant la lame de ressort 27. Tout en maintenant le couvercle 3 avec tous ses bords en face des bords correspondants du corps 1, le préposé fait tourner la clé 33 jusqu'à ce que le loquet 34 atteigne sa position verrouillée dans laquelle les ailes 36 s'engagent dans les logements 37 tandis que les ailes 52 s'engagent dans ces gâches 53. En même temps la goupille 43 pénètre de façon irréversible dans le trou 42 de sorte que le coffret se trouve irréversiblement fermé. Le préposé peut enlever la clé 33 hors de la serrure 32 et l'emmener, ce qui témoigne de la fermeture correcte du coffret 1.

Toute autre personne essayant ensuite d'ouvrir frauduleusement le coffret 1 ne peut pas utiliser la clé 33 ou un passe-partout. Si elle tente de tirer sur le couvercle 3 pour le séparer du corps 1, la force de traction sera transmise depuis le couvercle 3 au boîtier de la serrure 32 sur la plaque 54, aux gâches 53, au loquet 34, aux parois 37, au bloc de retenue 44, et au corps 1. En d'autres termes, grâce à l'existence de gâches pour le loquet à la fois sur le couvercle 3 et sur le corps 1, la traction n'est pas transmise par des pièces délicates de la serrure 32. Si la traction est très forte, les raccords cassables 18 vont céder avant que les moyens de verrouillage 29, 31 ne soient endommagés. Le corps 1 sera alors libéré de son mur support et l'effort de traction sera de ce fait interrompu. Toutefois, le couvercle 21 de chaque moyen de fixation 13 interdit l'accès à l'intérieur de la boîte même après rupture des liaisons 18.

Si quelqu'un tente d'ouvrir le coffret en perçant la serrure 32, ceci n'aura également que de faibles chances de succès car il serait très difficile de faire sortir le loquet 34 des gâches 37 et 52. En effet, même si le fraudeur réussit à séparer complètement le loquet 34 de la serrure 32, le loquet 34 est maintenu en place par les gâches 37 et 53 et par les moyens de blocage à ressort 41 à 43.

Le préposé ne peut pas enlever la clé 33 sans avoir correctement fermé le coffret. En particulier, s'il fait tourner la clé 33 pour placer le loquet 34 en position verrouillée sans que ce loquet ne soit engagé dans les moyens de retenue 37 du corps 1, il lui sera impossible de maintenir le couvercle 3 en position apparamment fermée. D'une part le loquet 34 empêchera les bords latéraux et inférieurs du couvercle 3 de venir en contact étroit avec les bords correspondants du corps 1 et d'autre part la lame de ressort 27 repoussera le couvercle 3 vers le bas. En conséquence, le couvercle 3 tombe nécessairement et le corps 1 reste visiblement ouvert.

Si le préposé tente d'empêcher le blocage par ressort du loquet 34 lorsqu'il vient en prise avec les logements 37 en introduisant l'objet 51 en forme de U des figures 13 et 14, cet objet en forme de U sera éjecté par les tenons 49 avant que la goupille 43 ne vienne en face du trou 42. Par conséquent le blocage par ressort se fera néanmoins et la réouverture du coffret sera bien interdite.

Comme les vis 58 du presse-garniture sont à l'intérieur du coffret, il est impossible d'accéder au coffret 1, une fois clos, en démontant les presse-garnitures 56.

Pour toutes ces raisons, il apparaîtra que l'invention fournit un moyen très efficace pour protéger des compteurs électriques ou analogues contre la fraude.

L'invention n'est pas limitée à la réalisation décrite et représentée et différentes modifications peuvent y être apportées. Par exemple au lieu d'être vertical, le plan de l'ouverture peut être oblique sous réserve que la pente soit suffisante pour permettre au couvercle 3 de glisser vers le bas lorsqu'il n'est pas verrouillé.

Les moyens pour maintenir de façon irréversible l'organe de verrouillage en position verrouillée peuvent être par exemple des rochets.

**Revendications**

1. Coffret, en particulier pour compteur électrique ou analogue nécessitant une protection contre la fraude, le vol et autre, comportant deux éléments de boîtier (1, 3), à savoir un corps creux (1) muni d'une ouverture (2) et un couvercle (3) prévu pour fermer l'ouverture (2) du corps (1), un premier de ces éléments de boîtier (3) portant un mécanisme de verrouillage (29) actionnable par une clé (33) et comprenant un organe de verrouillage (34) mobile par rapport audit premier élément de boîtier (3) entre une position de verrouillage qui permet la prise avec des moyens de retenue (37) de l'autre élément de boîtier (1), et une position déverrouillée, caractérisée en ce que le mécanisme de verrouillage (29) est conçu pour permettre d'enlever la clé (33) lorsque l'organe de verrouillage (34) est en position de verrouillage et pour retenir, sans possibilité d'enlèvement, la clé (33) lorsque l'organe de verrouillage (34) est en position déverrouillée, et en ce que le coffret comporte des moyens pour maintenir de façon irréversible l'organe de verrouillage (34) en position de verrouillage lorsque ce dernier (34) et les moyens de retenue (37) sont en prise mutuelle.

2. Coffret selon la revendication 1, caractérisé en ce que les moyens (41, 42, 43) pour maintenir l'organe de verrouillage (34) en position de verrouillage sont en partie portés par ledit autre élément de boîtier (1).

3. Coffret selon l'une des revendications 1 ou 2, caractérisé en ce que les moyens pour maintenir l'organe de verrouillage en position de verrouillage comportent des moyens de blocage à ressort (41, 42, 43).

4. Coffret selon la revendication 3, caractérisé en ce que les moyens de blocage à ressort comprennent des pièces de verrouillage (41, 42, 43) mutuellement coopérantes et en ce qu'au moins une (41) desdites pièces de verrouillage (41, 43) comporte des moyens de dégagement (49) prévus pour débarrasser une autre (43) desdites pièces de verrouillage des objets étrangers (51).

5. Coffret selon la revendication 4, caractérisé en ce que les moyens de blocage à ressort comprennent une goupille (43) sollicitée par un ressort et une pièce percée (41) qui peut se déplacer devant la goupille (43) lorsque le couvercle (3) est en train d'être fixé sur le corps (1), en ce que la goupille (43) est entourée d'un bossage (47) et en ce que la pièce percée (41) porte au moins un tenon (49) qui se déplace le long du bossage (47) pendant le déplacement de la pièce percée (41).

6. Coffret selon la revendication 5, caractérisé en ce qu'il y a deux tenons (49) et en ce que le bossage (47) présente sensiblement une forme en bateau allongée dans la direction de déplacement des tenons (49), la distance entre les tenons (49) étant sensiblement égale à la plus large dimension transversale du bossage (47).

7. Coffret selon l'une des revendications 5 ou 6, caractérisé en ce que la pièce percée (41) est fixée à l'organe de verrouillage (34) du mécanisme de verrouillage (29) et en ce que la goupille (43) sollicitée par un ressort est portée par ledit autre élément de boîtier (1).

8. Coffret selon l'une de revendications 1 à 7, caractérisé en ce que les deux éléments de boîtier (1, 3) comprennent des moyens de retenue (37, 53) prévus pour être en prise avec l'organe de verrouillage (34), en position de verrouillage de ce dernier.

9. Coffret selon la revendication 8, caractérisé en ce que les moyens de retenue (37, 53) et les moyens (41, 43) pour maintenir irréversiblement l'organe de verrouillage en position de verrouillage sont conçus pour positionner l'organe de verrouillage (34) indépendamment d'une serrure (32) actionnable par la clé (33).

10. Coffret selon l'une des revendications 8 ou 9, caractérisé en ce que l'organe de verrouillage (34) peut tourner autour d'un axe de rotation (XX) et est conçu pour coopérer avec des moyens de retenue (53) du premier élément de boîtier (3) dans deux régions situées de chaque côté de l'axe de rotation (XX), et avec des moyens de retenue (37) de l'autre élément de boîtier (1) dans deux régions situées de chaque côté de l'axe de rotation (XX).

11. Coffret selon l'une des revendications 1 - 10, caractérisé en ce qu'il comprend des moyens repoussant le couvercle en direction d'une position ouverte dégageant l'ouverture.

12. Coffret selon la revendication 11, caractérisé en ce que les moyens pour repousser le couvercle fonctionnent par le poids du couvercle (3).

13. Coffret selon la revendication 12, caractérisé en ce que l'ouverture (2) s'étend dans un plan à pente raide tandis que le corps (1) et un bord supérieur (28) du couvercle (3) peuvent venir en prise mutuelle, cette dernière permettant cependant le glissement des éléments de boîtier l'un par rapport à l'autre, le long de la pente dudit plan.

14. Coffret selon l'une des revendications 1 - 13, caractérisé en ce que le corps comporte des moyens (13) lui permettant d'être fixé à une structure support telle qu'un mur ou analogue (16), et en ce que lesdits moyens de fixation (13) sont reliés au corps (1) proprement dit par une liaison cassable (18).

15. Coffret selon la revendication 14, caractérisé en ce que les moyens de fixation (17) et la liaison cassable (18) sont isolés de l'intérieur du corps par un couvercle (21) fixé au corps (1) de façon à ne pas pouvoir être enlevé depuis l'extérieur du corps (1) même après rupture de la liaison cassable (18).

16. Coffret selon la revendication 15, caractérisé en ce que le couvercle (21) est fixé au corps (1) de façon à ne pas pouvoir être enlevé depuis l'intérieur du corps (1).


## Patentansprüche

1. Gehäuse, insbesondere für Elektrizitätszähler od. ähnl. Geräte, die einen Schutz gegen Betrug, Diebstahl u.a. erfordern, mit zwei Gehäuseteilen (1, 3), nämlich einem mit einer Öffnung (2) versehenen hohlen Körper (1) und einem zum Verschließen der Öffnung (2) des Körpers (1) vorgesehenen Deckel (3), wobei ein erster (3) dieser Gehäuseteile einen mit einem Schlüssel (33) betätigbaren Verriegelungsmechanismus (29) trägt, der ein Verriegelungsorgan (34) enthält, das in bezug auf den genannten ersten Gehäuseteil (3) zwischen einer Verriegelungsstellung, die den Eingriff mit Rückhaltemitteln (37) des anderen Gehäuseteils (1) erlaubt, und einer Entriegelungsstellung bewegbar ist, dadurch gekennzeichnet, daß der Verriegelungsmechanismus (29) so ausgebildet ist, daß er erlaubt, den Schlüssel (33) abzuziehen, wenn das Verriegelungsorgan (34) sich in der Verriegelungsstellung befindet, und den Schlüssel (33) festhält, ohne daß eine Möglichkeit besteht, den Schlüssel abzuziehen, wenn das Verriegelungsorgan sich in der Entriegelungsstellung befindet, und daß das Gehäuse Mittel enthält, die das Verriegelungsorgan (34) irreversibel in der Verriegelungsstellung halten, wenn letzteres (34) und die Rückhaltemittel (37) in gegenseitigem Eingriff stehen.

2. Gehäuse nach Anspruch 1, dadurch gekennzeichnet, daß die Mittel (41, 42, 43) zum Halten des Verriegelungsorgans (34) in der Verriegelungsstellung teilweise von dem genannten anderen Gehäuseteil (1) getragen werden.

3. Gehäuse nach Anspruch 1 oder 2, dadurch gekennzeichnet, daß die Mittel zum Halten des Verriegelungsorgans in der Verriegelungsstellung Feder-Blockierungsmittel (41, 42, 43) umfassen.

4. Gehäuse nach Anspruch 3, dadurch gekennzeichnet, daß die Feder-Blockierungsmittel untereinander zusammenwirkende Verriegelungsteile (41, 42, 43) enthalten, und daß mindestens einer (41) der genannten Verriegelungsteile (41, 43) Freilegemittel (49) zum Befreien eines anderen (43) der genannten Verriegelungsteile von Fremdkörpern (51) enthält.

5. Gehäuse nach Anspruch 4, dadurch gekennzeichnet, daß die Feder-Blockierungsmittel einen von einer Feder beaufschlagten Stift (43) und einen durchlochten Teil (41) umfassen, der sich vor dem Stift (43) verschieben kann, wenn der Deckel (3) gerade an dem Körper (1) befestigt wird, daß der Stift (43) von einem Vorsprung (47) umgeben ist und daß der durchlochte Teil (41) mindestens einen Zapfen (49) trägt, der sich bei der Verschiebung des durchlochten Teils (41) längs des Vorsprunges (47) bewegt.

6. Gehäuse nach Anspruch 5, dadurch gekennzeichnet, daß zwei Zapfen (49) vorhanden sind und daß der Vorsprung (47) im wesentlichen eine in Bewegungsrichtung der Zapfen (49) langgestreckte Wannenform aufweist, wobei die Entfernung zwischen den Zapfen (49) im wesentlichen gleich ist der größten Querabmessung des Vorsprunges (47).

7. Gehäuse nach Anspruch 5 oder 6, dadurch gekennzeichnet, daß der durchlochte Teil (41) an dem Verriegelungsorgan (34) des Verriegelungsmechanismus (29) befestigt ist und daß der von einer Feder beaufschlagte Stift (43) von dem anderen Gehäuseteil (1) getragen wird.

8. Gehäuse nach einem der Ansprüche 1 bis 7, dadurch gekennzeichnet, daß die beiden Gehäuseteile (1, 3) Rückhaltemittel (37, 53) umfassen, die dazu vorgesehen sind, in der Verriegelungsstellung des Verriegelungsorgans (34) mit letzterem in Eingriff zu stehen.

9. Gehäuse nach Anspruch 8, dadurch gekennzeichnet, daß die Rückhaltemittel (37, 53) und die Mittel (41, 43) zum irreversiblen Halten des Verriegelungsorgans in der Verriegelungsstellung so gestaltet sind, daß sie das Verriegelungsorgan (34) unabhängig von einem mit dem Schlüssel (33) betätigbaren Schloß (32) positionieren.

10. Gehäuse nach Anspruch 8 oder 9, dadurch gekennzeichnet, daß das Verriegelungsorgan (34) um eine Drehachse (XX) drehbar und so gestaltet ist, daß es mit den Rückhaltemitteln (53) des ersten Gehäuseteils (3) in zwei beidseits der Drehachse (XX) gelegenen Zonen und mit den Rückhaltemitteln (37) des anderen Gehäusteils (1) in zwei beidseits der Drehachse (XX) gelegenen Zonen zusammenwirkt.

11. Gehäuse nach einem der Ansprüche 1 bis 10, dadurch gekennzeichnet, daß es Mittel enthält, die den Deckel in Richtung einer die Öffnung freigebenden Offenstellung zurückdrücken.

12. Gehäuse nach Anspruch 11, dadurch gekennzeichnet, daß die Mittel zum Zurückdrücken des Deckels zufolge des Gewichts des Deckels (3) arbeiten.

13. Gehäuse nach Anspruch 12, dadurch gekennzeichnet, daß die Öffnung (2) sich in einer stark geneigten Ebene erstreckt, während der Körper (1) und ein oberer Rand (28) des Deckels (3) in gegenseitigen Eingriff gelangen können, wobei letzterer jedoch ein Gleiten der Gehäuseteile in bezug aufeinander längs der Neigung der genannten Ebene erlaubt.

14. Gehäuse nach einem der Ansprüche 1 bis 13, dadurch gekennzeichnet, daß der Körper Mittel (13) umfaßt, die ihm erlauben, auf einem Träger, wie an einer Wand od. dgl. (16) befestigt zu werden, und daß die genannten Befestigungsmittel (13) mit dem eigentlichen Körper (1) mittels einer leicht zerbrechlichen Verbindung (18) verbunden sind.

15. Gehäuse nach Anspruch 14, dadurch gekennzeichnet, daß die Befestigungsmittel (17) und die leicht zerbrechliche Verbindung (18) vom Inneren des Körpers durch einen Deckel (21) getrennt sind, der an dem Körper (1) so befestigt ist, daß er von der Außenseite des Körpers (1) her selbst nach einem Bruch der leicht zerbrechlichen Verbindung (18) nicht abnehmbar ist.

16. Gehäuse nach Anspruch 15, dadurch gekennzeichnet, daß der Deckel (21) an dem Körper (1) so befestigt ist, daß er vom Inneren des Körpers (1) her nicht abnehmbar ist.

## Claims

1. A box, especially for an electric meter or similar apparatus needing protection against fraud, theft and the like, comprising two casing portions (1, 3) which are a hollow body (1) provided with an aperture (2) and a cover (3) adapted to close the aperture (2) of the body (1), one of the casing portions (3) carrying a locking mechanism (29) operable by a key (33) and provided with a locking member (34) movable with respect to said casing portion (3) between an operative position allowing engagement of a retaining means (37) of the other casing portion (1) and a release position, characterized by the locking mechanism (29) being adapted so as to allow removal of the key (33) when the locking member (34) is in the locked position and to unremovably retain the key (33) when the locking member (34) is in the release position and the box comprising means for irreversibly maintaining the locking member (34) in the locked position when the locking member (34) and the retaining means (37) are mutually engaged.

2. A box according to claim 1, characterized in that said means (41, 42, 43) for maintaining the locking member (34) in the locked position are partly carried by said other casing portion (1).

3. A box according to claims 1 or 2, characterized in that said means for maintaining the locking member in the locked position comprises spring catch means (41, 42, 43)

4. A box according to claim 3, characterized in that the spring catch means comprises mutually cooperating locking elements (41, 42, 43) and in that at least one (41) of said locking elements (41, 43) is provided with clearing means (49) adapted to clear another said locking element (43) of foreign objects (51).

5. A box according to claim 4, characterized in that the spring catch means comprises a spring loaded bolt (43) and an apertured element (41) displaceable in front of the bolt (43) when the cover (3) is being secured to the body (1), in that the bolt (43) is surrounded by a boss (47) and in that the apertured element (41) carries at least one peg (49) travelling alongside the boss (47) during displacement of the apertured element (41).

6. A box according to claim 5, characterized in that there are two pegs (49) and in that the boss (47) has substantially a boat shape elongated in the travelling direction of the pegs (49), the distance between the pegs (49) being substantially equal to the broadest transverse dimension of the boss (47).

7. A box according to one of claims 5 or 6, characterized in that the apertured element (41) is secured to the locking member (34) of the locking mechanism (29) and the spring loaded bolt (43) is carried by said other casing portion (1).

8. A box according to one of claims 1 - 7, characterized in that both casing portions (1, 3) are provided with retaining means (37, 53) adapted to engage the locking member (34) in the locked position thereof.

9. A box according to claim 8, characterized in that the retaining means (37, 53) and the means (41, 43) for irreversibly maintaining the locking member in the locked position are adapted to position the locking member (34) independently of a lock (32) actuated by the key (33).

10. A box according to claims 8 or 9, characterized in that the locking member (34) is rotatable about an axis of rotation (XX) and is adapted so as to cooperate with retaining means (53) of the one casing portion (3) in two regions located on each side of the axis of rotation (XX) and with retaining means (37) of the other casing portion (1) in two regions located on each side of the axis of rotation (XX).

11. A box according to one of claims 1 - 10, characterized by comprising means biasing the cover towards an open position clearing the aperture.

12. A box according to claim 11, characterized in that the biasing means are operable by gravity of the cover (3).

13. A box according to claim 12, characterized in that the aperture (2) extends in a steep plane while the body (1) and a top edge (28) of the cover (3) are able of a mutual engagement which however allows the body (1) and the cover (3) to slide with respect to each other along the slope of said plane.

14. A box according to one of claims 1 - 13, characterized in that the body is provided with means (13) allowing it to be fastened to a support structure such as a wall or the like (16), and in that said fastening means (13) are connected to the body (1) proper by a breakable connection (18).

15. A box according to claim 14, characterized in that the fastening means (17) and the breakable connection (18) are insulated from the interior of the body by a lid (21) which is secured to the body (1) so as to be unremovable from outside the body (1) even after breakage of the breakable connection (18).

16. A box according to claim 15, characterized in that the lid (21) is secured to the body (1) so as to be unremovable from inside the body (1).

FIG.1

FIG.2

FIG.3

FIG.4

FIG.6

FIG.5

FIG.11

FIG.12

FIG.13

FIG.14

FIG. 8

FIG. 7

FIG. 10

FIG. 9